# EUROPEAN PATENT APPLICATION

(11) **EP 4 618 234 A1**
(43) Date of publication of application: **17.09.2025**
(21) Application number: 25163524.9
(22) Date of filing: 13.03.2025
(51) Int. Cl.: H01M 10/42, H01M 50/105, H01M 50/284

(54) **BATTERY PACK**

(30) Priority: 14.03.2024 KR 20240035980
(71) Applicant: SAMSUNG SDI CO., LTD., Yongin-si, Gyeonggi-do 17084 (KR)
(72) Inventor: KIM, YOUNGJUN, 17084 Yongin-si, Gyeonggi-do (KR)
(74) Representative: Gulde & Partner

(57) **Abstract**

Provided is a battery pack. The battery pack includes a battery cell, a pouch covering the battery cell and including a terrace formed in a first direction in which an electrode of the battery cell is drawn out, a flexible circuit board including a controller configured to control charging and discharging of the battery cell, a connector communicating with an external device, and a connection portion flexibly connecting the controller to the connector, a protection element arranged on the controller on a first surface of the flexible circuit board, and a molding portion covering the protection element on the controller, in which at least part of the flexible circuit board on a second surface opposite to the first surface is arranged opposite to a module seating surface of the terrace.

## Description

### FIELD

One or more embodiments relate to a battery pack.

### BACKGROUND

Secondary batteries can be charged and discharged a plurality of times, thus enabling repeated use. Secondary batteries are used as energy sources for mobile devices, electric vehicles, hybrid vehicles, electric bicycles, uninterruptible power supplies, etc. According to the type of external device they are applied to, secondary batteries are used in the form of a single battery or in the form of a pack in which multiple battery cells are connected and grouped into one unit.

### SUMMARY

One or more embodiments include a battery pack capable of controlling charging and discharging of a battery cell through a protection element arranged on a flexible circuit board.

One or more embodiments include a battery pack including a protection circuit module having a high volumetric efficiency by being miniaturized with a flexible circuit board.

Additional aspects will be set forth in part in the description which follows and, in part, will be apparent from the description, or may be learned by practice of the presented embodiments of the present disclosure.

According to one or more embodiments, a battery pack includes a battery cell, a pouch covering the battery cell and including a terrace formed in a first direction in which an electrode of the battery cell is drawn out, a flexible circuit board including a controller configured to control charging and discharging of the battery cell, a connector communicating with an external device, and a connection portion flexibly connecting the controller to the connector, a protection element arranged on the controller on a first surface of the flexible circuit board, and a molding portion covering the protection element on the controller, in which at least part of the flexible circuit board on a second surface opposite to the first surface is arranged opposite to a module seating surface of the terrace.

The flexible circuit board, the protection element, and the molding portion may form a protection circuit module.

The protection circuit module may be fixed such that the second surface of the flexible circuit board is opposite to the module seating surface.

The module seating surface may be arranged in a second direction intersecting the first direction on the pouch.

The terrace, the flexible circuit board, the protection element, and the molding portion may be arranged to overlap in the second direction.

The terrace, the flexible circuit board, the protection element, and the molding portion may be sequentially arranged in the stated order in the second direction.

The molding portion may include a thermally conductive material to discharge to outside the protection circuit module heat emitted from the protection element.

A thickness of the flexible circuit board may fall within a range of about 0.1 mm to about 0.5 mm. A distance between the first surface and the second surface may fall within a range of about 0.1 mm to about 0.5 mm.

The flexible circuit board may further include a connection tab arranged on the second surface and electrically connected to the electrode of the battery cell.

The connection portion of the flexible circuit board may include at least part extending in a direction intersecting a direction in which the controller extends so as to connect the controller to the connector. The pouch may include an accommodation portion accommodating the battery cell, and the accommodation portion may be formed on opposite sides of the pouch in a third direction intersecting the first direction.

### BRIEF DESCRIPTION OF THE DRAWINGS

The above and other aspects, features, and advantages of certain embodiments of the present disclosure will be more apparent from the following description taken in conjunction with the accompanying drawings.
FIG. 1 is a perspective view of a battery pack according to embodiments;
FIG. 2 is an assembly view of a battery pack according to embodiments;
FIG. 3 is a view for describing a terrace of a pouch according to embodiments;
FIG. 4 is a view for describing one surface of a flexible circuit board according to embodiments;
FIG. 5 is a view for describing the other surface opposite to the one surface of the flexible circuit board shown in FIG. 4;
FIG. 6 is a coupling view of a molding portion and a flexible circuit board, according to embodiments;
FIG. 7 is a view for describing a molding portion formed on a flexible circuit board, according to embodiments;
FIG. 8 is a view for describing a structure in which a protection circuit module is connected to a first electrode and a second electrode of a battery cell, according to embodiments; and
FIG. 9 is view for describing a structure in which a protection circuit module is arranged on a terrace of a pouch, according to embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Hereinafter, embodiments of the present disclosure will be described in detail with reference to the accompanying drawings. The terms and words used in the present specification and claims described above should not be construed as being limited to ordinary or dictionary meanings, and should be interpreted as meanings and concepts consistent with the technical idea of the present disclosure based on the principle that the present inventors may appropriately define the concept of the terms to describe their invention in the best way. Therefore, it should be understood that the configurations shown in the drawings and embodiments described in this specification are merely the most preferred embodiments of the present disclosure, and do not represent all of the technical ideas of the present disclosure, such that there may be various equivalents and variations that replace them at the time of filing the present application. If used herein, "comprise, include" and/or "comprising, including" specify mentioned shapes, numbers, steps, operations, members, components, and/or presence of these groups, and do not exclude the presence or addition of one or more different shapes, numbers, operations, members, components, and /or groups. If embodiments of the present disclosure are described, "can" or "may" may include "one or more embodiments of the present disclosure".

To help understanding of the present disclosure, the accompanying drawings are not shown according to the actual scale, but the dimensions of some components may be exaggerated. The same reference numeral may be given to the same component in different embodiments.

The statement that two comparison targets are 'the same' as each other may mean that they are 'substantially the same' as each other. Thus, a case where they are 'substantially the same' as each other may include a case where they have a deviation regarded as a low level, e.g., a deviation of 5 % or less. If a uniform parameter is uniform in a predetermined area, it may mean that it is uniform from an average point of view.

Although first, second, etc., may be used to describe various components, these components are not limited by these terms. These terms are only used to distinguish one component from other components, and unless specifically stated to the contrary, a first component may be a second component.

Throughout the specification, unless specially stated to the contrary, each component may be singular or plural.

If a component is arranged on "a top portion (or a bottom portion)" of another component or "on (or under)" the other component, it may mean not only a case where the component is arranged adjacent to a top surface (or a bottom surface) of the other component, but also a case where another component may be interposed between the other component and the component arranged on (or under) the other component.

If a component is described as being "connected", "coupled", or "connected" to another component, it should be understood that the components are directly connected or connectable to each other, but another component may be "interposed" between the components, or the components may be may be "connected", "coupled", or "connected" to each other through another component. If a portion is electrically coupled to another portion, this may include not only a case where they are directly connected to each other, but also a case where they are connected with another element therebetween. Throughout the specification, "A and/or B" may mean A, B, or A and B unless specially stated otherwise. That is, "and/or" may include all or any combination of a plurality of items listed. "C to D" may mean at least C but not more than D, unless specially stated otherwise.

Hereinafter, a battery pack according to embodiments will be described with reference to the accompanying drawings.

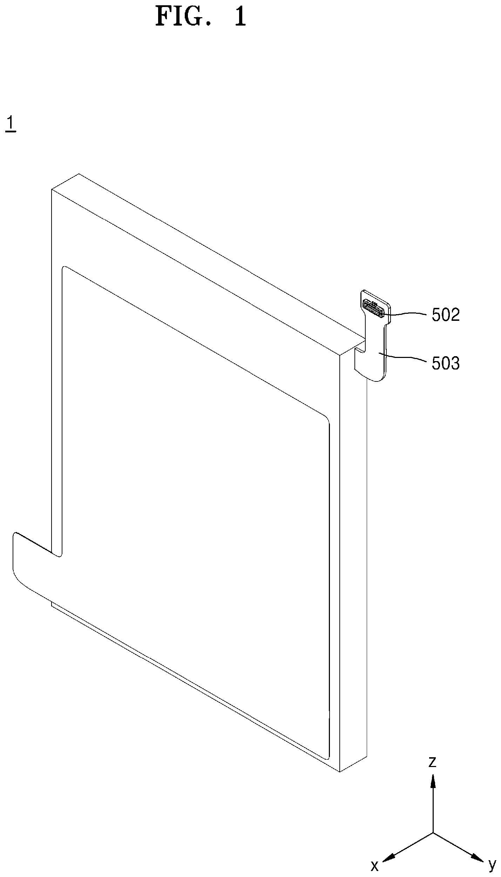

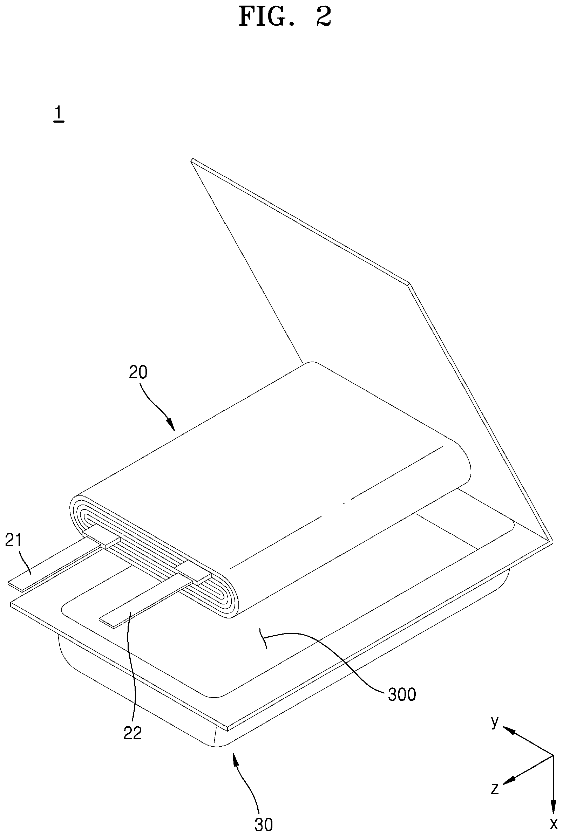

FIG. 1 is a perspective view of a battery pack 1 according to embodiments. FIG. 2 is an assembly view of the battery pack 1 according to embodiments.

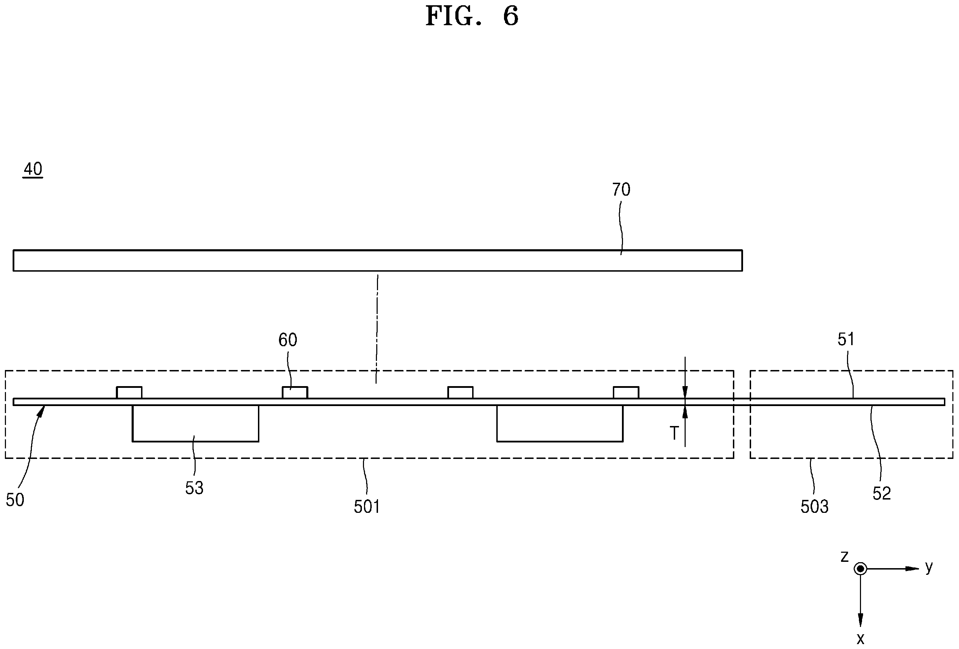

Referring to FIGS. 1 and 2, the battery pack 1 according to embodiments includes a battery cell 20. The battery cell 20 may include a negative plate, a positive plate, and a separator arranged therebetween. A negative tab electrically connected to a negative uncoated portion may be provided in the negative plate, and a positive tab electrically connected to a positive uncoated portion may be provided in the positive plate. The negative tab may be a first electrode 21. The positive tab may be a second electrode 22. The battery cell 20 may be, but not limited to, an electrode assembly including the first electrode 21 and the second electrode 22. The battery pack 1 according to embodiments may include a pouch 30 configured to accommodate the battery cell 20. The pouch 30 accommodates the battery cell 20. The battery cell 20 may be accommodated inside the pouch 30. The pouch 30 covers the battery cell 20. The pouch 30 may expose at least part of the first electrode 21 and the second electrode 22. The at least part of the first electrode 21 and the second electrode 22 may be exposed to outside of the pouch 30. The first electrode 21 and the second electrode 22 exposed to the outside of the pouch 30 may be electrically connected to the protection circuit module 40 described later with reference to FIG. 6.

The pouch 30 according to embodiments may include an accommodation portion 300 accommodating the battery cell 20. The battery cell 20 may be accommodated inside the accommodation portion 300 of the pouch 30.

Referring back to FIG. 2, the accommodation portion 300 of the pouch 30 may be formed in a direction intersecting a first direction z in which the first electrode 21 and the second electrode 22 of the battery cell 20 are drawn out. More specifically, the accommodation portion 300 of the pouch 30 may be formed in an x-axis direction. The accommodation portion 300 of the pouch 30 may be foamed in a side to accommodate the battery cell 20. However, a way to form the accommodation portion 300 of the pouch 30 is not limited to the foregoing description. For example, the accommodation portion 300 of the pouch 30 may be formed on opposite sides of the pouch 30 in the direction intersecting the first direction z, unlike in FIG. 2.

The accommodation portion 300 of the pouch 30 according to embodiments may be formed on the opposite sides of the pouch 30 in the direction intersecting the first direction z in which the first electrode 21 and the second electrode 22 of the battery cell 20 are drawn out. More specifically, the accommodation portion 300 of the pouch 30 may be formed in the x-axis direction and in a direction opposite to the x-axis direction. If the accommodation portion 300 of the pouch 30 is formed on the opposite sides of the pouch 30, it may mean that the pouch 30 is foamed on opposite sides. However, the foregoing description of a shape and processing of the accommodation portion 300 of the pouch 30 is merely an example and is not limited thereto. The accommodation portion 300 of the pouch 30 configured to accommodate the battery cell 20 may also be configured variously.

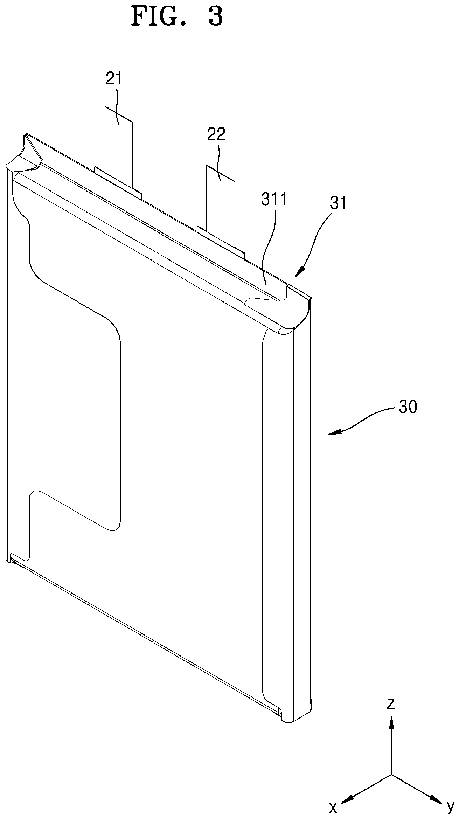

FIG. 3 is a view for illustrating a terrace 31 of the pouch 30 according to embodiments. FIG. 3 is a view illustrating each corner of the pouch 30 shown in FIG. 2 being sealed.

Referring to FIGS. 2 and 3, the first electrode 21 and the second electrode 22 of the battery cell 20 according to embodiments may be drawn out in the first direction z. The first direction z may be an upward direction of the pouch 30. The first electrode 21 and the second electrode 22 of the battery cell 20 may be drawn out in the upward direction of the pouch 30.

The pouch 30 according to embodiments may include the terrace 31 formed thereon. The pouch 30 may include the terrace 31 formed in the first direction z in which the first electrode 21 and the second electrode 22 of the battery cell 20 are drawn out. The terrace 31 may be a portion in which the protection circuit module 40 described below with reference to FIG. 6 is arranged.

The terrace 31 according to embodiments may include a module seating surface 311 formed in a direction facing a front surface of the pouch 30. The module seating surface 311 may be a surface of the terrace 31 formed in the direction facing the front surface of the pouch 30. The module seating surface 311 may be a surface of the terrace 31 formed in the x-axis direction. The module seating surface 311 may be a portion in which the protection circuit module 40 described below with reference to FIG. 6 is arranged. However, a description of arrangement and functions of the terrace 31 and the module seating surface 311 is merely an example, without being limited thereto.

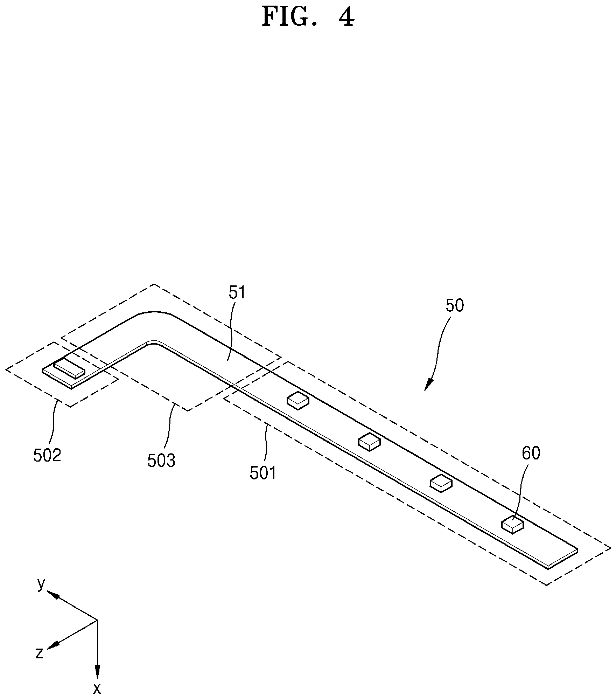

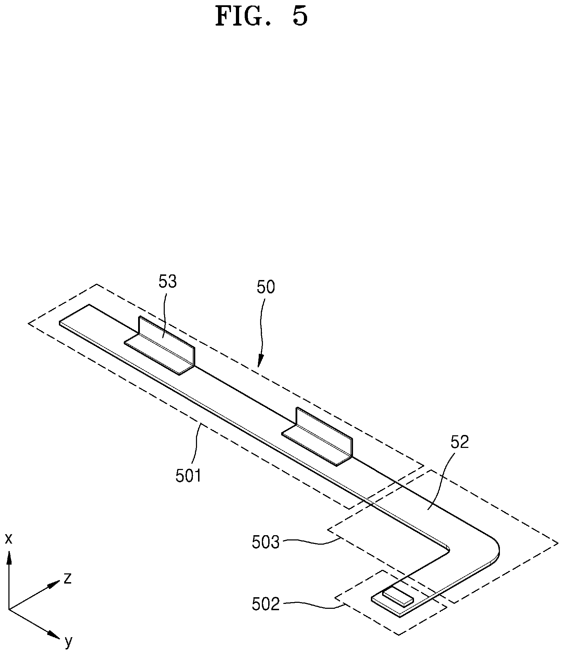

FIG. 4 is a view illustrating a surface of a flexible circuit board 50 according to embodiments. FIG. 5 is a view illustrating the other surface opposite to the surface of the flexible circuit board 50 shown in FIG. 4.

Referring to FIGS. 3 to 5, the battery pack 1 according to embodiments may include the flexible circuit board 50. The flexible circuit board 50 includes a controller 501 that controls charging and discharging of the battery cell 20. The controller 501 may be electrically connected to the battery cell 20. The controller 501 may selectively block or allow power supplied to the battery cell 20. The controller 501 may prevent excessive power from being supplied to the battery cell 20. The controller 501 may prevent a function of the battery cell 20 from being degraded due to excessive power supply to the battery cell 20.

The controller 501 according to embodiments may be a region where the protection element 60 is arranged on the flexible circuit board 50. The protection element 60 may control charging and discharging of the battery cell 20. However, the function of the protection element 60 is not limited to the foregoing description.

The flexible circuit board 50 according to embodiments may include a first surface 51 and a second surface 52 opposite to the first surface 51. The protection element 60 may be arranged on the first surface 51 of the flexible circuit board 50. The protection element 60 may be arranged on the controller 501 on the first surface 51 of the flexible circuit board 50. However, arrangement of the protection element 60 is not limited to the foregoing description.

The flexible circuit board 50 according to embodiments may include a connection tab 53 electrically connected to the first electrode 21 and the second electrode 22 of the battery cell 20. The connection tab 53 may be arranged on the second surface 52 of the flexible circuit board 50. The connection tab 53 may be arranged on the controller 501 of the flexible circuit board 50. The connection tab 53 may be arranged on the other surface opposite to the surface of the flexible circuit board 50 on which the protection element 60 is arranged. However, arrangement of the connection tab 53 is not limited to the foregoing description.

Referring back to FIGS. 1 and 3 to 5, the flexible circuit board 50 according to embodiments may include a connector 502 communicating with an external device. The connector 502 may electrically connect the external device to the battery cell 20.

Meanwhile, the flexible circuit board 50 according to embodiments may include a connection portion 503 flexibly connecting the controller 501 to the connector 502. The connection portion 503 may flexibly connect the controller 501 to the connector 502. If the connection portion 503 flexibly connects the controller 501 to the connector 502, it may mean that a relative position of the connector 502 and the controller 501 is adjusted through the connection portion 503. If the connection portion 503 flexibly connects the controller 501 to the connector 502, it may mean that the connection portion 503 adjusts a position of the connector 502 through deformation thereof. If the connection portion 503 flexibly connects the controller 501 to the connector 502, it may mean that a user freely arranges the connector 502 by changing a form of the connection portion 503. That is, the connection portion 503 may adjust an arrangement position of the connector 502 by being flexibly deformed.

The controller 501, the connector 502, and the connection portion 503 according to embodiments may be provided as one body. The controller 501, the connector 502, and the connection portion 503 may include a flexible material having a form that may be changed by an external force. The controller 501, the connector 502, and the connection portion 503 may be continuously connected. On the controller 501, the connector 502, and the connection portion 503, the first surface 51 and the second surface 52 may be continuously connected. That is, each of the first surface 51 and the second surface 52 may be formed smoothly on the controller 501, the connector 502, and the connection portion 503. However, the shapes of the controller 501, the connector 502, and the connection portion 503 are not limited to the foregoing description.

The connection portion 503 of the flexible circuit board 50 according to embodiments may include at least part extending in a direction intersecting a direction in which the controller 501 extends so as to connect the controller 501 to the connector 502. If at least part of the connection portion 503 of the flexible circuit board 50 extends in the direction intersecting the direction in which the controller 501 extends, it may be easy to adjust the position of the connector 502. However, the foregoing description of the shape and function of the connection portion 503 is merely an example, and the present disclosure is not limited thereto.

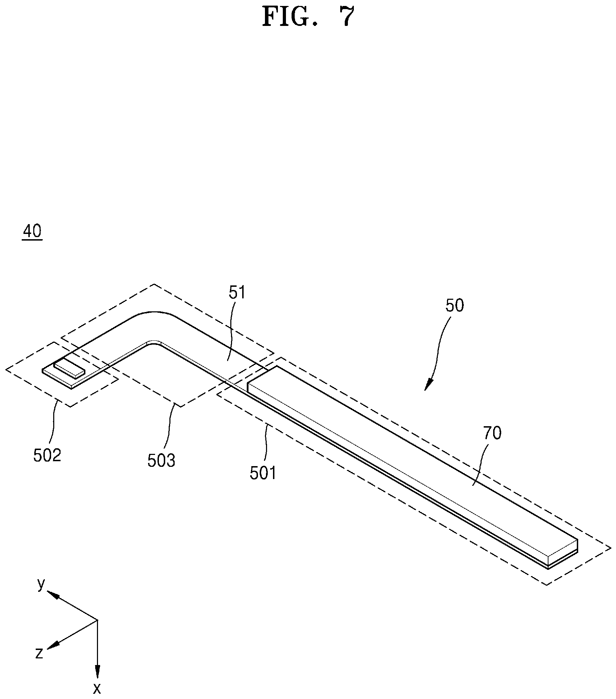

FIG. 6 is a coupling view of a molding portion 70 and the flexible circuit board 50 according to embodiments. FIG. 7 is a view illustrating the molding portion 70 formed on the flexible circuit board 50 according to embodiments.

Referring to FIGS. 4, 6 and 7, the battery pack 1 according to embodiments may include the molding portion 70. The molding portion 70 may be arranged on the first surface 51 of the flexible circuit board 50. The molding portion 70 may cover the controller 501 of the flexible circuit board 50. The molding portion 70 may be arranged on the same surface as the surface of the flexible circuit board 50 on which the protection element 60 is arranged. The molding portion 70 may cover the protection element 60 on the controller 501.

The molding portion 70 according to embodiments may support the flexible circuit board 50. The molding portion 70 may support the controller 501 of the flexible circuit board 50. The molding portion 70 may extend in the direction in which the controller 501 of the flexible circuit board 50 extends. The molding portion 70 may extend in a second direction y. The molding portion 70 may include a solid material. The material of the molding portion 70 may include resin. The material of the molding portion 70 may include metal. The molding portion 70 may prevent the controller 501 of the flexible circuit board 50 from being deformed by an external force. The molding portion 70 may prevent a circuit of the controller 501 of the flexible circuit board 50 from being damaged. However, the function of the molding portion 70 is not limited to the foregoing description.

Meanwhile, the flexible circuit board 50, the protection element 60, and the molding portion 70 according to embodiments may form a protection circuit module 40. The protection circuit module 40 may include the flexible circuit board 50, the protection element 60, and the molding portion 70. Hereinbelow, a structure in which the protection circuit module 40 is arranged on the terrace 31 of the pouch 30 will be described.

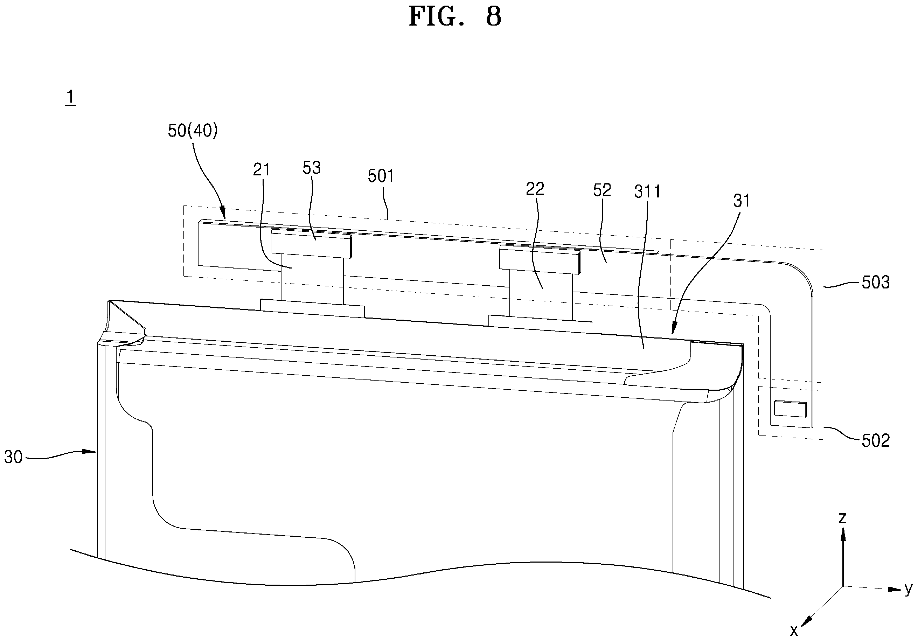

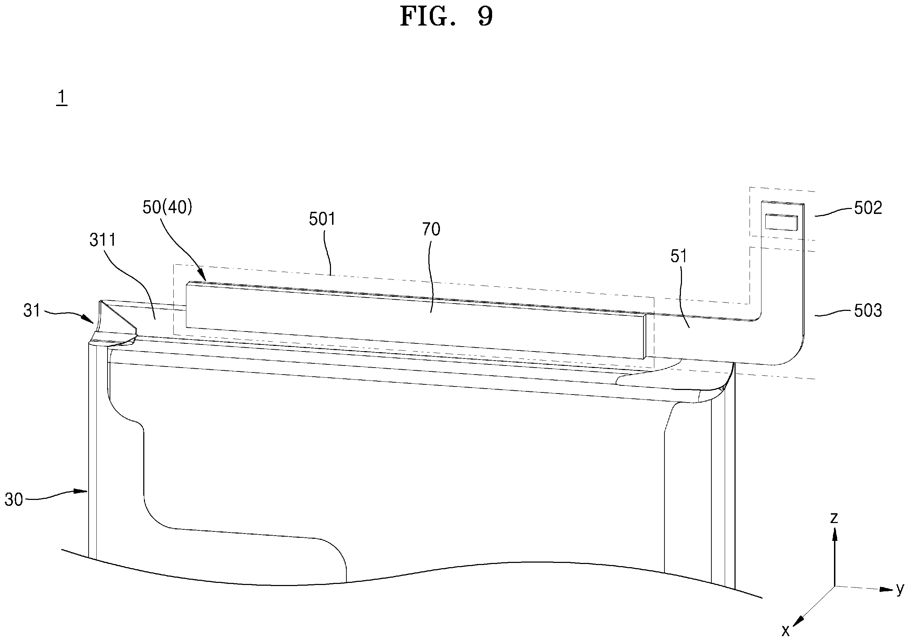

FIG. 8 is a view illustrating a structure in which the protection circuit module 40 is connected to the first electrode 21 and the second electrode 22 of the battery cell 20, according to embodiments. FIG. 9 is view for describing a structure in which the protection circuit module 40 is arranged on the terrace 31 of the pouch 30, according to embodiments.

Referring to FIGS. 6 to 9, the connection tab 53 of the flexible circuit board 50 according to embodiments may be electrically connected to the first electrode 21 and the second electrode 22 of the battery cell 20. If the connection tab 53 is connected to the first electrode 21 and the second electrode 22 of the battery cell 20, it may mean that the battery cell 20 is electrically connected to the controller 501 of the flexible circuit board 50. If the connection tab 53 is connected to the first terminal and the second terminal of the battery cell 20, it may mean that the battery cell 20 is electrically connected to the protection circuit module 40.

The protection circuit module 40 according to embodiments may be arranged on the terrace 31 of the pouch 30 through pivoting after the connection tab 53 is connected to the first electrode 21 and the second electrode 22 of the battery cell 20. The protection circuit module 40 may be arranged on the terrace 31 of the pouch 30 by pivoting in a third direction x as an axis. Pivoting of the protection circuit module 40 may mean that the second surface 52 of the flexible circuit board 50 is arranged from a direction facing the front surface of the pouch 30 to a direction facing the rear surface of the pouch 30. Pivoting of the protection circuit module 40 may mean that the second surface 52 of the flexible circuit board 50 is arranged from a direction facing the second direction y to a direction opposite to the second direction y. Pivoting of the protection circuit module 40 may mean that the first surface 51 of the flexible circuit board 50 is arranged from the direction facing the rear surface of the pouch 30 to the direction facing the front surface of the pouch 30. Pivoting of the protection circuit module 40 may mean that the first surface 51 of the flexible circuit board 50 is arranged from the direction opposite to the second direction y to the direction facing the second direction y.

Referring back to FIGS. 6, 7, and 9, at least part of the second surface 52 of the flexible circuit board 50 according to embodiments may be arranged opposite to the module seating surface 311 of the terrace 31. The module seating surface 311 of the terrace 31 may be a surface of the terrace 31 formed in a direction facing the front surface of the pouch 30. The module seating surface 311 of the terrace 31 may be arranged in the second direction y. The module seating surface 311 of the terrace 31 may be a surface of the terrace 31 formed in the second direction y.

The protection circuit module 40 according to embodiments may be fixed such that the second surface 52 of the flexible circuit board 50 is opposite to the module seating surface 311 of the terrace 31. To fix the protection circuit module 40 such that the second surface 52 of the flexible circuit board 50 is opposite to the module seating surface 311, the protection circuit module 40 and the module seating surface 311 may be arranged to overlap in the second direction y.

The terrace 31, the flexible circuit board 50, the protection element 60, and the molding portion 70 according to embodiments may be arranged to overlap in the second direction y. The terrace 31, the flexible circuit board 50, the protection element 60, and the molding portion 70 according to embodiments may be sequentially arranged in the stated order in the second direction y. Heat emitted by the protection element 60 may be discharged in the second direction y. The heat emitted by the protection element 60 may be discharged through the molding portion 70 in the second direction y. The molding portion 70 may include a material having high thermal conductivity. The molding portion 70 may include a thermally conductive material to discharge the heat emitted from the protection element 60 to outside of the protection circuit module 40. The molding portion 70 may discharge the heat emitted from the protection element 60 to outside of the battery pack 1.

Meanwhile, the flexible circuit board 50 may have a predetermined thickness T in the second direction y. The thickness T of the flexible circuit board 50 may be a distance between the first surface 51 and the second surface 52 of the flexible circuit board 50. When the thickness T of the flexible circuit board 50 is not thick, it is possible to prevent the thickness T of the protection circuit module 40 from becoming thick. When the thickness T of the flexible circuit board 50 is not thick, the miniaturized protection circuit module 40 may be provided. When the thickness T of the flexible circuit board 50 is not thick, the volumetric efficiency of the battery pack 1 may be high. When the thickness T of the flexible circuit board 50 is not thick, the energy efficiency of the battery pack 1 may be high. In particular, when the thickness T of the controller 501 of the flexible circuit board 50 is not thick, the terrace 31 and the protection circuit module 40 overlapping in the second direction y may be prevented from being excessively thick in the second direction y.

The thickness T of the flexible circuit board 50 according to embodiments may be about 0.05 mm to about 1 mm. The thickness T of the flexible circuit board 50 may be about 0.1 mm to about 0.5 mm. A distance between the first surface 51 and the second surface 52 of the flexible circuit board 50 may be about 0.05 mm to about 1 mm. The distance between the first surface 51 and the second surface 52 of the flexible circuit board 50 may be about 0.1 mm to about 0.5 mm. However, the foregoing description of the thickness T of the flexible circuit board 50 is merely an example, and the present disclosure is not limited thereto.

Although the present disclosure has been described with reference to an example shown in the drawings, it will be understood by those of ordinary skill in the art that various modifications and equivalent other examples may be made from the shown example.

The battery pack according to the present disclosure may be capable of controlling charging and discharging of a battery cell through a protection element arranged on a flexible circuit board.

The battery pack according to the present disclosure may include a protection circuit module having a high volumetric efficiency by being miniaturized with a flexible circuit board.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the present disclosure as defined by the following claims.

## Claims

1. A battery pack comprising:
a battery cell (20);
a pouch (30) covering the battery cell (20) and comprising a terrace (31) formed in a first direction (z) in which an electrode of the battery cell (20) is drawn out;
a flexible circuit board (50) comprising:
a controller (501) configured to control charging and discharging of the battery cell (20);
a connector (502) communicating with an external device; and
a connection portion (503) flexibly connecting the controller (501) to the connector (502);
a protection element (60) arranged on the controller (501) on a first surface (51) of the flexible circuit board (50); and
a molding portion (70) covering the protection element (60) on the controller (501);
wherein at least part of the flexible circuit board (50) on a second surface (52) opposite to the first surface (51) is arranged opposite to a module seating surface (311) of the terrace (31).

2. The battery pack as claimed in claim 1, wherein the flexible circuit board (50), the protection element (60), and the molding portion (70) form a protection circuit module (40).

3. The battery pack as claimed in claim 2, wherein the protection circuit module (40) is fixed such that the second surface (52) of the flexible circuit board (50) is located opposite to the module seating surface (311).

4. The battery pack as claimed in claim 3, wherein the module seating surface (311) is arranged in a second direction (y) intersecting the first direction (z) on the pouch (30).

5. The battery pack as claimed in claim 4, wherein the terrace (31), the flexible circuit board (50), the protection element (60), and the molding portion (70) are arranged to overlap one another in the second direction (y).

6. The battery pack as claimed in claim 5, wherein the terrace (31), the flexible circuit board (50), the protection element (60), and the molding portion (70) are sequentially arranged in the stated order in the second direction (y).

7. The battery pack as claimed in claim 6, wherein the molding portion (70) comprises a thermally conductive material to discharge to outside of the protection circuit module (40) heat emitted from the protection element (60).

8. The battery pack as claimed in claims 1 to 7, wherein a thickness (T) of the flexible circuit board (50) falls within a range of about 0.1 mm to about 0.5 mm.

9. The battery pack as claimed in claim 8, wherein a distance between the first surface (51) and the second surface (52) falls within a range of about 0.1 mm to about 0.5 mm.

10. The battery pack as claimed in claim 9, wherein the flexible circuit board (50) comprises a connection tab (53) arranged on the second surface (52) and electrically connected to the electrode of the battery cell (20).

11. The battery pack as claimed in claims 1 to 10, wherein the connection portion (503) of the flexible circuit board (50) comprises at least part extending in a direction intersecting a direction in which the controller (501) extends, so as to connect the controller (501) to the connector (502).

12. The battery pack as claimed in claims 1 to 11, wherein the pouch (30) comprises an accommodation portion (300) accommodating the battery cell (20), and the accommodation portion (300) is formed on opposite sides of the pouch (30) in a third direction (x) intersecting the first direction (z).

13. The battery pack as claimed in claims 1 to 12, wherein the controller (501) prevents excessive power from being supplied to the battery cell (20), thus preventing a function of the battery cell (20) from being degraded.

14. The battery pack as claimed in claims 3 to 13, wherein the protection circuit module (40) and the module seating surface (311) are arranged to overlap in a second direction (y), thus enabling a stable fixation.
